# EUROPEAN PATENT APPLICATION

(11) **EP 4 299 660 A1**
(43) Date of publication of application: **03.01.2024**
(21) Application number: 22893224.0
(22) Date of filing: 10.11.2022
(51) Int. Cl.: C08K 5/57, C08K 5/5419, C08K 5/544, C08K 5/00, C08K 5/14, C08K 5/23, H01L 23/29

(54) **ENCAPSULANT COMPOSITION FOR OPTICAL DEVICE AND ENCAPSULANT FILM FOR OPTICAL DEVICE USING SAME**

(30) Priority: 10.11.2021 KR 20210154112
(71) Applicant: LG Chem, Ltd., Seoul 07336 (KR)
(72) Inventor: LEE, Jin Kuk, Daejeon 34122 (KR); LEE, Eun Jung, Daejeon 34122 (KR); PARK, Sang Eun, Daejeon 34122 (KR); HONG, Sang Hyun, Daejeon 34122 (KR); LEE, Young Woo, Daejeon 34122 (KR); JUN, Jung Ho, Daejeon 34122 (KR)
(74) Representative: Hoffmann Eitle
(86) International application number: PCT/KR2022/017651
(87) International publication number: WO 2023/085805

(57) **Abstract**

The present invention relates to an encapsulant composition for an optical device, comprising an ethylene/alpha-olefin copolymer having high volume resistance and light transmittance, and an encapsulant film for an optical device using the same.

## Description

### TECHNICAL FIELD

This application claims the benefit of Korean Patent Application No. 10-2021-0154112, filed on November 10, 2021, in the Korean Intellectual Property Office, the contents of which are incorporated herein by reference.

The present invention relates to an encapsulant composition for an optical device having high volume resistance and light transmittance and an encapsulant film for an optical device using the same.

### BACKGROUND ART

As global environmental problems, energy problems, etc. get worse and worse, solar cells receive attention as a clean energy generating means without fear of exhaustion. If solar cells are used outside such as the roof of a building, generally, a module type is used. In order to obtain a crystalline solar cell module when manufacturing a solar cell module, protection sheet for solar cell module (surface side transparent protection member)/solar cell encapsulant/crystalline solar cell device crystalline solar cell device/solar cell encapsulant/protection sheet for solar cell module (back side protection member) are stacked in order. Meanwhile, in order to manufacture a thin film-based solar cell module, thin film-type solar cell device/solar cell encapsulant/protection sheet for solar cell module (back side protection member) are stacked in order.

As the solar cell encapsulant, generally, an ethylene/vinyl acetate copolymer or an ethylene/alpha-olefin copolymer, etc. is used. In addition, in the solar cell encapsulant, a light stabilizer is generally included as an additive considering the requirement on climate-resistance for a long time. In addition, considering the adhesiveness of a transparent surface side protection member or a back side protection member represented by glass, a silane coupling agent is commonly included in the solar cell encapsulant.

Particularly, an ethylene/vinyl acetate copolymer (EVA) sheet has been widely used, because transparency, flexibility and adhesiveness are excellent. An ethylene·vinyl acetate copolymer (EVA) film has been widely used, because transparency, flexibility and adhesiveness are excellent. However, if an EVA composition is used as the constituent material of a solar cell encapsulant, it has been apprehended that components such as an acetic acid gas generated by the decomposition of EVA might influence a solar cell device.

An ethylene/alpha-olefin copolymer has no problems of a resin on hydrolysis and may solve the problems of deteriorating lifetime or reliability. However, since the ethylene/alpha-olefin copolymer does not include a polar group in the resin, miscibility with a polar crosslinking auxiliary agent included as the constituent material of the conventional solar cell encapsulant, has been deteriorated, it took a long time for soaking, and there were problems with productivity.

As described above, the development of a crosslinking auxiliary agent that could improve the productivity of a solar cell encapsulant including an ethylene/alpha-olefin copolymer which could be usefully utilized as a material having excellent volume resistance and requiring high insulation, such as a solar cell encapsulant, is still required.

### [Prior Art Document]

### [Patent Document]

(Patent Document 1) Korean Laid-open Patent No. 2018-0063669

### DETAILED DESCRIPTION OF THE INVENTION

### TECHNICAL PROBLEM

Tasks to solve in the present invention is to provide an encapsulant composition for an optical device, including a crosslinking auxiliary agent having excellent miscibility with an olefin-based copolymer and showing high volume resistance and excellent insulation thereby.

Another tasks to solve in the present invention is to provide an encapsulant film for an optical device manufactured using the encapsulant composition for an optical device.

Another tasks to solve in the present invention is to provide an optical device module including the encapsulant film for an optical device.

### TECHNICAL SOLUTION

To solve the above tasks, the present invention provides an encapsulant composition for an optical device, an encapsulant film for an optical device, and an optical device module.
[1] The present invention provides an encapsulant composition for an optical device, the encapsulant composition comprising: (1) an olefin-based copolymer; (2) a crosslinking agent; (3) a silane coupling agent; and (d) a compound represented by Formula 1. 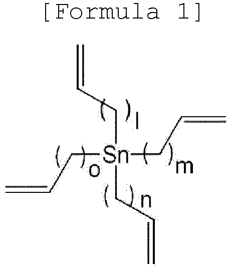 In Formula 1, l, m, n, and o are each independently an integer of 0 to 4.
[2] The present invention provides the encapsulant composition for an optical device according to [1], wherein the (1) olefin-based copolymer satisfies the following conditions:
   (a) a density of 0.85 to 0.90 g/cc, and (b) a melt index of 0.1 to 100 g/10 min.
[3] The present invention provides the encapsulant composition for an optical device according to [1] or [2], wherein the (1) olefin-based copolymer is an ethylene alpha-olefin copolymer.
[4] The present invention provides the encapsulant composition for an optical device according to any one among [1] to [3], wherein the (1) olefin-based copolymer has a volume resistance of 1.0 × 10¹⁵ Ω·cm or more.
[5] The present invention provides the encapsulant composition for an optical device according to any one among [1] to [4], wherein the crosslinking agent is one or two or more selected from the group consisting of an organic peroxide, a hydroperoxide and an azo compound.
[6] The present invention provides the encapsulant composition for an optical device according to any one among [1] to [5], wherein the crosslinking agent is one or more selected from the group consisting of t-butylcumylperoxide, di-t-butyl peroxide, di-cumyl peroxide, 2,5-dimethyl-2,5-di(t-butylperoxy)hexane, 2,5-dimethyl-2,5-di(t-butylperoxy)-3-hexyne, cumene hydroperoxide, diisopropyl benzene hydroperoxide, 2,5-dimethyl-2,5-di(hydroperoxy)hexane, t-butyl hydroperoxide, bis-3,5,5-trimethylhexanoyl peroxide, octanoyl peroxide, benzoyl peroxide, o-methylbenzoyl peroxide, 2,4-dichlorobenzoyl peroxide, t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, 2,5-dimethyl-2,5-di(benzoylperoxy)-3-hexyne, methyl ethyl ketone peroxide, cyclohexanone peroxide, azobisisobutyronitrile and azobis(2,4-dimethylvaleronitrile).
[7] The present invention provides the encapsulant composition for an optical device according any one among [1] to [6], wherein the silane coupling agent is one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane (MEMO), vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.
[8] The present invention provides the encapsulant composition for an optical device according to any one among [1] to [7], wherein, in Formula 1, l, m, n, and o are each independently an integer of 0 to 2.
[9] The present invention provides the encapsulant composition for an optical device according to any one among [1] to [8], wherein the compound of Formula 1 is tetravinyltin.
[10] The present invention provides the encapsulant composition for an optical device according to any one among [1] to [9], wherein the encapsulant composition for an optical device comprises: (1) 80 to 99 parts by weight of the olefin-based copolymer; (2) 0.1 to 9 parts by weight of the organic peroxide; (3) 0.01 to 2 parts by weight of the silane coupling agent; and (d) 0.1 to 9 parts by weight of the compound of Formula 1.
[11] The present invention provides the encapsulant composition for an optical device according to any one among [1] to [10], wherein the encapsulant composition for an optical device further comprises (5) a crosslinking auxiliary agent in addition to the compound of Formula 1, and the (5) crosslinking auxiliary agent comprises one or more of an allyl group or a (meth)acryloxy group.
[12] The present invention provides the encapsulant composition for an optical device according to [11], wherein the (5) crosslinking auxiliary agent comprises one or more selected from the group consisting of triallyl isocyanurate (TAIC), triallyl cyanurate, diallyl phthalate, diallyl fumarate, diallyl maleate, ethylene glycol diacrylate, ethylene glycol dimethacrylate, and trimethylolpropane trimethacrylate.
[13] The present invention provides the encapsulant composition for an optical device according to [11] or [12], wherein a weight ratio of the (4) compound of Formula 1 and the (5) crosslinking auxiliary agent is 20:80 to 80:20.
[14] The present invention provides an encapsulant film for an optical device, the encapsulant film comprising an olefin-based copolymer and a compound of Formula 1. 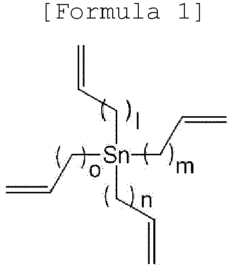 In Formula 1, l, m, n, and o are each independently an integer of 0 to 4.
[15] The present invention provides an optical device module, comprising an optical device, and the encapsulant film for an optical device according to [14].

### ADVANTAGEOUS EFFECTS

The encapsulant composition for an optical device of the present invention includes a compound containing tin, having excellent miscibility with an olefin-based copolymer, as a crosslinking auxiliary agent, and shows excellent volume resistance and light transmittance, and accordingly, could be widely used for various uses in electrical and electronic industrial fields.

### BRIEF DESCRIPTION OF DRAWING

FIG. 1 is a graph made as soaking torque curves, showing soaking torque values in accordance with stirring time during soaking a crosslinking agent, a crosslinking auxiliary agent, and a silane coupling agent in an ethylene/1-butene copolymer, measured in each of Examples 1 to 5.
FIG. 2 is a graph made as a soaking torque curve, showing soaking torque values in accordance with stirring time during soaking a crosslinking agent, a crosslinking auxiliary agent, and a silane coupling agent in an ethylene/1-butene copolymer, measured in Comparative Example 1.
FIG. 3 is a graph made as a soaking torque curve, showing soaking torque values in accordance with stirring time during soaking a crosslinking agent, a crosslinking auxiliary agent, and a silane coupling agent in an ethylene/1-butene copolymer, measured in Comparative Example 3.

### MODE FOR CARRYING OUT THE INVENTION

Hereinafter, the present invention will be described in more detail to assist the understanding of the present invention.

It will be understood that words or terms used in the present disclosure and claims shall not be interpreted as the meaning defined in commonly used dictionaries. It will be further understood that the words or terms should be interpreted as having a meaning that is consistent with their meaning in the context of the relevant art and the technical idea of the invention, based on the principle that an inventor may properly define the meaning of the words or terms to best explain the invention.

### [Encapsulant composition for optical device]

The encapsulant composition for an optical device of the present invention is characterized in comprising (1) an olefin-based copolymer; (2) a crosslinking agent; (3) a silane coupling agent; and (d) a compound represented by Formula 1.

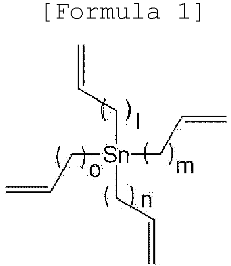

In Formula 1, l, m, n, and o are each independently an integer of 0 to 4.

The present invention relates to an encapsulant composition for an optical device, having high volume resistance and showing excellent electrical insulation. Particularly, the encapsulant composition for an optical device of the present invention includes an olefin-based copolymer instead of ethylene vinyl alcohol (EVA) applied in the conventional encapsulant composition for an optical device, and solves the problems of the hydrolysis of the acetate group of the ethylene vinyl alcohol in a humid environment to form acetic acid, thereby improving the durability and reliability of an optical device module. In addition, by applying the compound represented by Formula 1 in an olefin-based copolymer as a crosslinking auxiliary agent, problems of delaying the soaking of a crosslinking agent due to the insufficient miscibility of a polar crosslinking auxiliary agent which has been applied in the conventional ethylene vinyl alcohol with an olefin-based copolymer which does not including a polar group, could be solved, and a high degree of crosslinking, volume resistance and light transmittance could be achieved.

### (1) Olefin-based copolymer

The (1) olefin-based copolymer included in the encapsulant composition for an optical device according to an embodiment of the present invention may satisfy (a) a density of 0.85 to 0.90 g/cc, and (b) a melt index of 0.1 to 100 g/10 min.

The (a) density of the olefin-based copolymer may particularly be 0.850 g/cc or more, 0.855 g/cc or more, 0.860 g/cc or more, 0.865 g/cc or more, or 0.870 g/cc to 0.900 g/cc or less, 0.895 g/cc or less, 0.890 g/cc or less, 0.885 g/cc or less, 0.880 g/cc or less, 0.875 g/cc or less, or 0.870 g/cc or less. If the density of the olefin-based copolymer is too high, the light transmittance of an encapsulant for an optical device manufactured by using an encapsulant composition for an optical device may be reduced due to the crystal phase included in the olefin-based copolymer, but if the olefin-based copolymer satisfies the above-described density range, high light transmittance may be shown.

The (b) melt index of the olefin-based copolymer may be 0.1 g/10 min or more, 0.5 g/10 min or more, 1.0 g/10 min or more, 1.5 g/10 min or more, 2.0 g/10 min or more, 2.5 g/10 min or more, 5.0 g/10 min or more, or 10.0 g/10 min or more to 100 g/10 min or less, 95 g/10 min or less, 90 g/10 min or less, 85 g/10 min or less, 80 g/10 min or less, 75 g/10 min or less, 70 g/10 min or less, 60 g/10 min or less, or 50 g/10 min or less. If the melt index of the olefin-based copolymer is deviated from the above-described range and too low or high, there may be problems in that the moldability of the encapsulant composition for an optical device may become poor, and stable extrusion may become difficult. However, if the olefin-based copolymer satisfies the above melt index range, the moldability of the encapsulant composition for an optical device may be excellent, and an encapsulant for an optical device, and an encapsulant sheet for an optical device could be extruded stably.

The (1) olefin-based copolymer included in the encapsulant composition for an optical device according to an embodiment of the present invention may be an ethylene/alpha-olefin copolymer.

Generally, the density of the ethylene/alpha-olefin copolymer may be influenced by the type and amount of a monomer used during polymerization, the degree of polymerization, or the like, and in the case of a copolymer, the influence by the amount of a comonomer is large. With the increase of the amount of the comonomer, an ethylene/alpha-olefin copolymer having a low density may be prepared, and the amount of the comonomer introducible in the copolymer may be dependent on the intrinsic copolymerization properties of a catalyst.

The ethylene/alpha-olefin copolymer included in the encapsulant composition for an optical device of the present invention may show a low density and excellent processability as described above.

The ethylene/alpha-olefin copolymer is prepared by copolymerizing ethylene and an alpha-olefin-based monomer, and in this case, the alpha-olefin which means a moiety derived from an alpha-olefin-based monomer in the copolymer may be C4 to C20 alpha-olefin, particularly, propylene, 1-butene, 1-pentene, 4-methyl-1-pentene, 1-hexene, 1-heptene, 1-octene, 1-decene, 1-undecene, 1-dodecene, 1-tetradecene, 1-hexadecene, 1-eicosene, etc., and any one among them or mixtures of two or more thereof may be used.

Among them, the alpha-olefin may be 1-butene, 1-hexene or 1-octene, preferably, 1-butene, 1-hexene, or a combination thereof.

In addition, in the ethylene/alpha-olefin copolymer, the alpha-olefin content may be suitably selected in the range satisfying the physical conditions, particularly, greater than 0 to 99 mol%, or 10 to 50 mol%, without limitation.

In addition, in an embodiment of the encapsulant composition for an optical device of the present invention, the (1) olefin-based copolymer may be an ethylene alpha-olefin copolymer having a volume resistance of 1.0 × 10¹⁵ Ω·cm or more, particularly, 3.0 × 10¹⁵ Ω·cm or more, 5.0 × 10¹⁵ Ω·cm, 7.0 × 10¹⁵ Ω·cm or more, 1.0 × 10¹⁶ Ω·cm or more, 3.0 × 10¹⁶ Ω·cm or more, or 5.0 × 10¹⁶ Ω·cm or more. If the volume resistance of the (1) olefin-based copolymer is too low, the volume resistance of the encapsulant composition for an optical device may not reach a suitable level after crosslinking, but if the volume resistance of the (1) olefin-based copolymer satisfies the above value, the encapsulant composition for an optical device may show excellent volume resistance after crosslinking. The upper limit of the volume resistance of the (1) olefin-based copolymer is not specifically limited, but could be, considering the volume resistance commonly shown by an olefin-based copolymer and the difficulty in the preparation of an olefin-based copolymer having high volume resistance, 9.9 × 10¹⁶ Ω·cm or less, 9.0 × 10¹⁶ Ω·cm or less, 7.0 × 10¹⁶ Ω·cm or less, 5.0 × 10¹⁶ Ω·cm or less, 3.0 × 10¹⁶ Ω·cm or less, 2.5 × 10¹⁶ Ω·cm or less, or 2.0 × 10¹⁶ Ω·cm or less.

### (2) Crosslinking agent

The crosslinking agent may use various crosslinking agents well-known in this technical field as long as it is a crosslinking compound capable of initiating radical polymerization or forming crosslinking bonds, for example, one or two or more selected from the group consisting of an organic peroxide, a hydroxyl peroxide and an azo compound.

In addition, in an embodiment of the present invention, the crosslinking agent may particularly be an organic peroxide.

The organic peroxide may be an organic peroxide having a one-hour half-life temperature of 120 to 135°C, for example, 120 to 130°C, 120 to 125°C, preferably, 121°C. The "one-hour half-life temperature" means a temperature at which the half-life of the crosslinking agent becomes one hour. According to the one-hour half-life temperature, the temperature at which radical initiation reaction is efficiently performed may become different. Therefore, in case of using the organic peroxide having the one-hour half-life temperature in the above-described range, radical initiation reaction, that is, crosslinking reaction in a lamination process temperature for manufacturing an optical device may be effectively performed.

The crosslinking agent may include one or more selected from the group consisting of dialkyl peroxides such as t-butylcumylperoxide, di-t-butyl peroxide, di-cumyl peroxide, 2,5-dimethyl-2,5-di(t-butylperoxy)hexane, and 2,5-dimethyl-2,5-di(t-butylperoxy)-3-hexyne; hydroperoxides such as cumene hydroperoxide, diisopropyl benzene hydroperoxide, 2,5-dimethyl-2,5-di(hydroperoxy)hexane, and t-butyl hydroperoxide; diacyl peroxides such as bis-3,5,5-trimethylhexanoyl peroxide, octanoyl peroxide, benzoyl peroxide, o-methylbenzoyl peroxide, and 2,4-dichlorobenzoyl peroxide; peroxy esters such as t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, and 2,5-dimethyl-2,5-di(benzoylperoxy)-3-hexyne; ketone peroxides such as methyl ethyl ketone peroxide and cyclohexanone peroxide, lauryl peroxide, and azo compounds such as azobisisobutyronitrile and azobis(2,4-dimethylvaleronitrile), may be used, without limitation.

### (3) Silane coupling agent

The silane coupling agent may use, for example, one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane (MEMO), vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.

### (4) Compound of Formula 1

The encapsulant composition for an optical device of the present invention includes a compound of Formula 1.

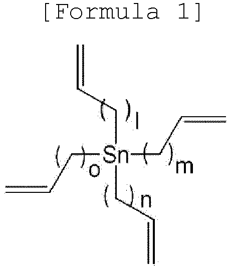

In Formula 1, l, m, n, and o are each independently an integer of 0 to 4.

In addition, in Formula 1, l, m, n, and o may be each independently an integer of 0 to 2.

In addition, the encapsulant composition for an optical device according to an embodiment of the present invention may particularly include tetravinyltin as the compound of Formula 1.

The compound of Formula 1 may be included in the encapsulant composition for an optical device as a crosslinking auxiliary agent, and the compound of Formula 1 has relatively low polarity when compared to a compound containing an allyl group such as triallyl isocyanurate (TAIC) which has been commonly used as a crosslinking auxiliary agent, and may show excellent miscibility with the (1) olefin-based copolymer included in the encapsulant composition for an optical device of the present invention. Accordingly, the soaking time of the crosslinking auxiliary agent may be reduced. In addition, in case of manufacturing an encapsulant for an optical device using the encapsulant composition for an optical device including the compound of Formula 1 as a crosslinking auxiliary agent, the encapsulant for an optical device manufactured may show high volume resistance.

The encapsulant composition for an optical device according to an embodiment of the present invention may include (1) 80 to 89 parts by weight of the olefin-based copolymer, (2) 0.1 to 9 parts by weight of the crosslinking agent, (3) 0.01 to 2 parts by weight of the silane coupling agent, and (4) 0.1 to 9 parts by weight of the compound of Formula 1. The amount of each component may mean a relative ratio between the weights of the components included in the encapsulant composition for an optical device.

The (1) olefin-based copolymer may be included in 80 to 99 parts by weight, particularly, 80 parts by weight or more, 82 parts by weight or more, 85 parts by weight or more, 86 parts by weight or more, 87 parts by weight or more, or 88 parts by weight or more to 99 parts by weight or less, 98 parts by weight or less, 97 parts by weight or less, 96 parts by weight or less, or 95 parts by weight or less. If the amount included of the (1) olefin-based copolymer is too small, it is difficult to show suitable mechanical properties including the tear resistance and tear strength of the encapsulant composition for an optical device. If the (1) olefin-based copolymer is included in the whole encapsulant composition for an optical device in the range, suitable mechanical properties could be shown as the encapsulant composition for an optical device.

The (2) crosslinking agent may be included in 0.1 to 9 parts by weight, particularly, 0.1 parts by weight or more, 0.2 parts by weight or more, 0.3 parts by weight or more, 0.4 parts by weight or more, 0.5 parts by weight or more, 0.6 parts by weight or more, 0.7 parts by weight or more, 0.8 parts by weight or more, or 1 part by weight or more to 9 parts by weight or less, 8 parts by weight or less, 7 parts by weight or less, 6 parts by weight or less, 5 parts by weight or less, 4 parts by weight or less, or 3 parts by weight or less. If the amount included of the (2) crosslinking agent is too small, crosslinking reaction may be difficult to occur, and if the amount included of the (2) crosslinking agent is too large, the volume resistance of the encapsulant for an optical device is reduced. If the (2) crosslinking agent is included in the whole encapsulant composition for an optical device in the above-described range, the encapsulant composition for an optical device may undergo suitable crosslinking reaction so that an encapsulant for an optical device may be prepared, and the encapsulant for an optical device thus prepared may show high volume resistance.

The (3) silane coupling agent may be included in 0.01 to 2 parts by weight, particularly, 0.01 parts by weight or more, 0.02 parts by weight or more, 0.05 parts by weight or more, 0.07 parts by weight or more, 0.09 parts by weight or more, 0.1 parts by weight or more, or 0.15 parts by weight or more to 2 parts by weight or less, 1.8 parts by weight or less, 1.7 parts by weight or less, 1.5 parts by weight or less, 1.2 parts by weight or less, 1.0 part by weight or less, 0.8 parts by weight or less, 0.7 parts by weight or less, 0.5 parts by weight or less, or 0.4 parts by weight or less. If the amount included of the (3) silane coupling agent is too small, adhesiveness with respect to the substrate, for example, a glass substrate of the encapsulant composition for an optical device, may be low, and it is difficult to show suitable performance as the encapsulant for an optical device, and if the amount included of the (3) silane coupling agent is too excessive, the volume resistance of the encapsulant for an optical device may be reduced unsuitably. If the (3) silane coupling agent is included in the whole encapsulant composition for an optical device in the above-described range, the encapsulant composition for an optical device shows excellent adhesiveness with respect to the substrate of an optical device or a glass substrate where an optical device is placed, and moisture penetration, or the like could be effectively blocked, excellent performance of the optical device may be maintained for a long time, and the encapsulant for an optical device may show high volume resistance.

The (4) compound of Formula 1 may be included in 0.1 to 9 parts by weight, particularly, 0.1 parts by weight or more, 0.2 parts by weight or more, 0.3 parts by weight or more, 0.4 parts by weight or more, 0.5 parts by weight or more, 0.6 parts by weight or more, 0.7 parts by weight or more, 0.8 parts by weight or more, or 1 part by weight or more to 9 parts by weight or less, 8 parts by weight or less, 7 parts by weight or less, 6 parts by weight or less, 5 parts by weight or less, 4 parts by weight or less, or 3 parts by weight or less. If the amount included of the (4) compound of Formula 1 is too small, crosslinking reaction may hardly occur, and if the amount included of the (4) compound of Formula 1 is too large, the volume resistance of the encapsulant for an optical device may be reduced. If the (4) compound of Formula 1 is included in the encapsulant composition for an optical device in the above-described range, the encapsulant composition for an optical device may undergo suitable crosslinking reaction so that an encapsulant for an optical device may be prepared, and the encapsulant for an optical device thus manufactured may show high volume resistance.

In addition, the encapsulant composition for an optical device may additionally include (5) a crosslinking auxiliary agent in addition to the compound of Formula 1.

The (5) crosslinking auxiliary agent may use various crosslinking auxiliary agents well-known in this technical field, for example, a compound containing at least one or more unsaturated groups including an allyl group or a (meth)acryloxy group.

As the (5) crosslinking auxiliary agent may include, for example, a polyallyl compound such as triallyl isocyanurate (TAIC), triallyl cyanurate, diallyl phthalate, diallyl fumarate and diallyl maleate, and the compound containing the (meth)acryloxy group may include, for example, a poly(meth)acryloxy compound such as ethylene glycol diacrylate, ethylene glycol dimethacrylate, and trimethylolpropane trimethacryate, without specific limitation.

If the encapsulant composition for an optical device according to an embodiment of the present invention additionally include the (5) crosslinking auxiliary agent other than the compound of Formula 1, the weight ratio of the (4) compound of Formula 1 and the (5) crosslinking auxiliary agent may be 20:80 to 80:20, particularly, 21:79 to 79:21, 22:78 to 78:22, 23:77 to 77:23, 24:76 to 76:24, or 25:75 to 75:25. If the encapsulant composition for an optical device according to an embodiment of the present invention additionally include the (5) crosslinking auxiliary agent other than the compound of Formula 1, the sum included of the (4) compound of Formula 1 and the (5) crosslinking auxiliary agent may be 0.1 to 9 parts by weight, particularly, 0.1 parts by weight or more, 0.2 parts by weight or more, 0.3 parts by weight or more, 0.4 parts by weight or more, 0.5 parts by weight or more, 0.6 parts by weight or more, 0.7 parts by weight or more, 0.8 parts by weight or more, or 1 part by weight or more to 9 parts by weight or less, 8 parts by weight or less, 7 parts by weight or less, 6 parts by weight or less, 5 parts by weight or less, 4 parts by weight or less, or 3 parts by weight or less.

If the encapsulant composition for an optical device according to an embodiment of the present invention includes the (4) compound of Formula 1 and the (5) crosslinking auxiliary agent together, high volume resistance, a rapid soaking rate, and excellent light transmittance and adhesiveness may be satisfied, and an even higher degree of crosslinking may be achieved in contrast to a case of using only the (4) compound of Formula 1. In case of including the (4) compound of Formula 1 and the (5) crosslinking auxiliary agent together with an increasing ratio of the (5) crosslinking auxiliary agent against the (4) compound of Formula 1, the light transmittance may increase in contrast to a case of using the same amount of the crosslinking auxiliary agent. If the ratio of the (5) crosslinking auxiliary agent is reduced, a soaking rate, volume resistance and degree of crosslinking may increase, and the ratio may be suitably determined in the above-described range according to the physical properties to show.

In addition, the encapsulant composition for an optical device may additionally include one or more additives selected from a light stabilizer, a UV absorbent and a thermal stabilizer as necessary.

The light stabilizer may capture the active species of the photothermal initiation of a resin to prevent photooxidation according to the use of the composition applied. The type of the light stabilizer used is not specifically limited, and for example, known compounds such as a hindered amine-based compound and a hindered piperidine-based compound may be used.

According to the use, the UV absorbent may absorb ultraviolet rays from the sunlight, etc., transform into harmless thermal energy in a molecule, and play the role of preventing the excitation of the active species of photothermal initiation in the resin composition. Particular types of the UV absorbent used are not specifically limited, and for example, one or a mixture of two or more of benzophenone-based, benzotriazole-based, acrylnitrile-based, metal complex-based, hindered amine-based, inorganic including ultrafine particulate titanium oxide and ultrafine particulate zinc oxide UV absorbents, etc. may be used.

In addition, the thermal stabilizer may include a phosphor-based thermal stabilizer such as tris(2,4-di-tert-butylphenyl)phosphite, phosphorous acid, bis[2,4-bis(1,1-dimethylethyl)-6-methylphenyl]ethylester, tetrakis(2,4-di-tert-butylphenyl)[1,1-biphenyl]-4,4'-diylbisphosphonate and bis(2,4-di-tert-butylphenyl)pentaerythritol diphosphite; and a lactone-based thermal stabilizer such as the reaction product of 8-hydroxy-5,7-di-tert-butyl-furan-2-on and o-xylene, and one or two or more of them may be used.

The amounts of the light stabilizer, UV absorbent and/or thermal stabilizer are not specifically limited. That is, the amounts of the additives may be suitably selected considering the use of the resin composition, the shape or density of the additives, etc. Generally, the amounts may be suitably controlled in a range of 0.01 to 5 parts by weight based on 100 parts by weight of the total solid content of the encapsulant composition for an optical device.

In addition, the composition for an encapsulant film of the present invention may suitably and additionally include various additives well-known in this art according to the use of the resin component applied in addition to the above components.

In addition, the encapsulant composition for an optical device may be utilized in various molded articles by molding by injection, extrusion, etc. Particularly, the composition may be used in various optoelectronic devices, for example, as an encapsulant for the encapsulation of a device in a solar cell, and may be used as an industrial material applied in a lamination process with heating, etc., without limitation.

### [Encapsulant film for optical device and optical device module]

In addition, the present invention provides an encapsulant film for an optical device, comprising an olefin-based copolymer and a compound of Formula 1.

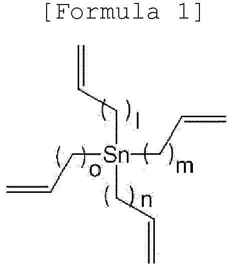

In Formula 1, l, m, n, and o are each independently an integer of 0 to 4.

In addition, in Formula 1, l, m, n, and o may be each independently an integer of 0 to 2.

In addition, the encapsulant composition for an optical device according to an embodiment of the present invention may particularly include tetravinyltin as the compound of Formula 1.

The explanation on the olefin-based copolymer and the compound of Formula 1 is the same as described above.

In addition, the present invention provides an encapsulant film for an optical device, including the encapsulant composition for an optical device.

The encapsulant film for an optical device of the present invention may be manufactured by molding a composition including the olefin-based copolymer and the compound of Formula 1, into a film or a sheet shape, and may particularly be manufactured by molding the encapsulant composition for an optical device into a film or a sheet shape. Such a molding method is not specifically limited, and may be formed into a sheet or a film by a common process, for example, a T die process or extrusion. For example, the manufacture of the encapsulant film for an optical device may be performed in situ using an apparatus in which the preparation of a resin composition using the encapsulant composition for an optical device and a process for forming a film or a sheet are connected.

The thickness of the encapsulant film for an optical device may be controlled to about 10 to 2,000 µm, or about 100 to 1,250 um considering the supporting efficiency and breaking possibility of a device in an optoelectronic device, the reduction of the weight or the workability of the device, and may be changed according to the particular use thereof.

In addition, the present invention provides an optical device module including an optical device and the encapsulant film for an optical device. The optical device may be, for example, a solar cell, and the optical device module may be a solar cell module. In the present invention, the optical device module may have a configuration in which the gaps between optical device cells, for example solar cells disposed in series or in parallel are filled with the encapsulant film for an optical device of the present invention, a glass surface is disposed on a side where the sunlight strikes, and a backside is protected by a back sheet, but is not limited thereto. Various types and shapes of the optical device modules or the solar cell modules, manufactured by including the encapsulant film for an optical device in this technical field may be applied in the present invention.

The glass surface may use tempered glass for protecting the optical device from external impact and preventing breaking, and may use low iron tempered glass having low iron content to prevent the reflection of the sunlight and to increase the transmittance of the sunlight, without limitation.

The back sheet is a climate-resistant film protecting the backside of the optical device module from exterior, for example, a fluorine-based resin sheet, a metal plate or metal film of aluminum, or the like, a cyclic olefin-based resin sheet, a polycarbonate-based resin sheet, a poly(meth)acryl-based resin sheet, a polyamide-based resin sheet, a polyester-based resin sheet, a laminated composite sheet of a climate-resistant film and a barrier film, or the like, without limitation.

Besides, the optical device module of the present invention may be manufactured by any methods well-known in this technical field only if including the encapsulant film for an optical device, without limitation.

The optical device module of the present invention is manufactured using an encapsulant film for an optical device, having excellent volume resistance, and the leakage of current outside through the movement of electrons in the optical device module may be prevented through the encapsulant film for an optical device. Accordingly, potential induced degradation (PID) phenomenon by which insulation is degraded, leakage current is generated, and the output of the module is rapidly degraded, may be largely restrained.

### Examples

Hereinafter, the present invention will be explained in more detail referring to embodiments. However, the embodiments are provided only for illustration, and the scope of the present invention is not limited thereto.

### [Manufacture of encapsulant film]

### Example 1

500 g of LUCENE^{™} LF675 of LG Chem, which is an ethylene/1-butene copolymer was dried using a convention oven of 40°C overnight. The density of the LUCENE^{™} LF675, measured by ASTM D1505 was 0.877 g/cm², and the melt index (190°C, 2.16 kg) measured by ASTM D1238 was 14.0 g/10 min. The bowl temperature of a viscometer (Thermo Electron (Karsruhe) Gmbh, Haake Modular Torque Viscometer) was set to 40°C. An ethylene/1-butene copolymer was added to the bowl, 1 part per hundred rubber (phr) of t-butyl 1-(2-ethylhexyl) monoperoxycarbonate (TBEC, Sigma Aldrich Co.) as a crosslinking agent, 0.375 phr of triallyl isocyanurate (TAIC, Sigma Aldrich Co.) as a crosslinking auxiliary agent, 0.125 phr of tetravinyltin (TVT, Sigma Aldrich Co.), and 0.2 phr of methacryloxypropyltrimethoxysilane (MEMO, Shinetsu Co.) as a silane coupling agent were added, using an electronic pipette. While stirring in 40 rpm, the change of a torque value in accordance with time was observed, and soaking was terminated when the torque value increased rapidly.

After that, by using a soaking completed specimen, an encapsulant film of a sheet shape was formed by press molding into an average thickness of 0.55 mm at a low temperature (under conditions of 90 to 100°C of an extruder barrel temperature) at which high-temperature crosslinking was not achieved, using a microextruder.

### Examples 2 to 5

Encapsulant compositions and encapsulant films for optical devices were manufactured by the same method as in Example 1 except for changing the amounts used of triallyl isocyanurate (TAIC) and tetravinyltin (TVT) as crosslinking auxiliary agents, as in Table 2 below.

### Comparative Example 1

An encapsulant composition and an encapsulant film for an optical device were manufactured by the same method as in Example 1 except for using ethylene vinyl acetate (EVA, EP28025, LG Chem,) instead of LUCENE^{™} LF675 of Preparation Example 1, and using only 0.5 phr of triallyl isocyanurate (TAIC) as the crosslinking auxiliary agent.

### Comparative Example 2

An encapsulant composition and an encapsulant film for an optical device were manufactured by the same method as in Example 1 except for not using the crosslinking auxiliary agent.

### Comparative Example 3

An encapsulant composition and an encapsulant film for an optical device were manufactured by the same method as in Example 1 except for using only 0.5 phr of triallyl isocyanurate (TAIC) as the crosslinking auxiliary agent.

### Comparative Example 4

An encapsulant composition and an encapsulant film for an optical device were manufactured by the same method as in Example 1 except for using 0.5 phr of triallyl isocyanurate (TAIC) and 0.5 phr of tetravinylsilane (TVS) as the crosslinking auxiliary agents.

### Comparative Example 5

An encapsulant composition and an encapsulant film for an optical device were manufactured by the same method as in Example 1 except for using only 0.5 phr of tetravinylsilane (TVS) as the crosslinking auxiliary agent.

### Comparative Example 6

An encapsulant composition and an encapsulant film for an optical device were manufactured by the same method as in Example 1 except for using 0.25 phr of triallyl isocyanurate (TAIC) and 0.25 phr of tetravinylsilane (TVS) as the crosslinking auxiliary agents.

**[Table 1]**

| | Resin type | Crosslink ing agent (phr) | Silane coupling agent (phr) | Crosslinking auxiliary agent | | |
|---|---|---|---|---|---|---|
| | | | | TAIC (phr) | TVT (phr) | TVS (phr) |
| Example 1 | POE | 1 | 0.2 | 0.375 | 0.125 | - |
| Example 2 | POE | 1 | 0.2 | 0.250 | 0.250 | - |
| Example 3 | POE | 1 | 0.2 | 0.125 | 0.375 | - |
| Example 4 | POE | 1 | 0.2 | - | 0.5 | - |
| Example 5 | POE | 1 | 0.2 | - | 1.0 | - |
| Comparative Example 1 | EVA | 1 | 0.2 | 0.5 | - | - |
| Comparative Example 2 | POE | 1 | 0.2 | - | - | - |
| Comparative Example 3 | POE | 1 | 0.2 | 0.5 | - | - |
| Comparative Example 4 | POE | 1 | 0.2 | 0.5 | - | 0.5 |
| Comparative Example 5 | POE | 1 | 0.2 | - | - | 0.5 |
| Comparative Example 6 | POE | 1 | 0.2 | 0.25 | - | 0.25 |

In Table 1, POE represents an ethylene 1-butene copolymer, EVA represents ethylene vinyl alcohol, TAIC represents triallyl isocyanurate, TVT represents tetravinyltin, and TVS represents tetravinylsilane.

### Experimental Examples

### [Analysis of encapsulant film]

Between two releasing films (thickness: about 100 pm), the encapsulant film with a thickness of 0.5 mm (15 cm × 15 cm) was put, and laminated at a process temperature of 150°C for a process time of 20 minutes (vacuum for 5 minutes/pressurizing for 1 minute/maintaining pressure for 14 minutes) in a vacuum laminator for crosslinking.

### (1) Soaking rate

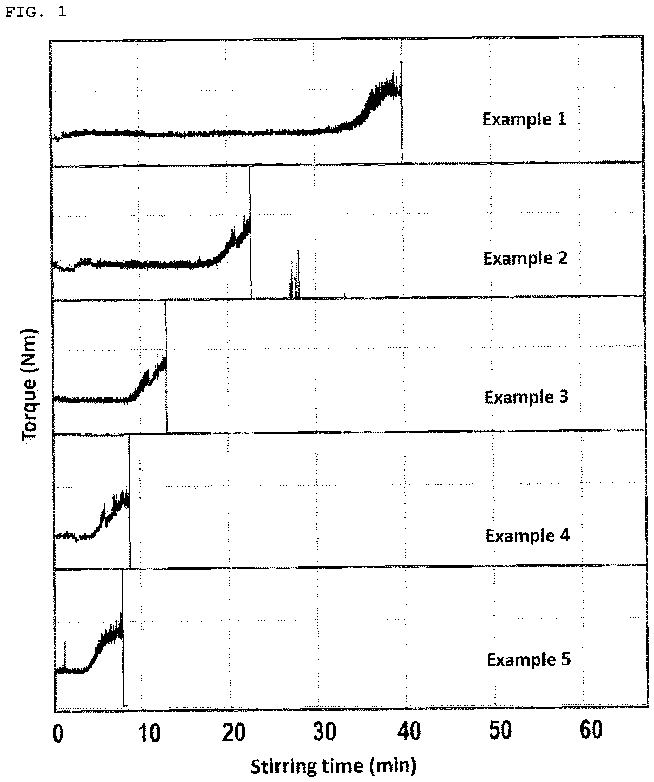

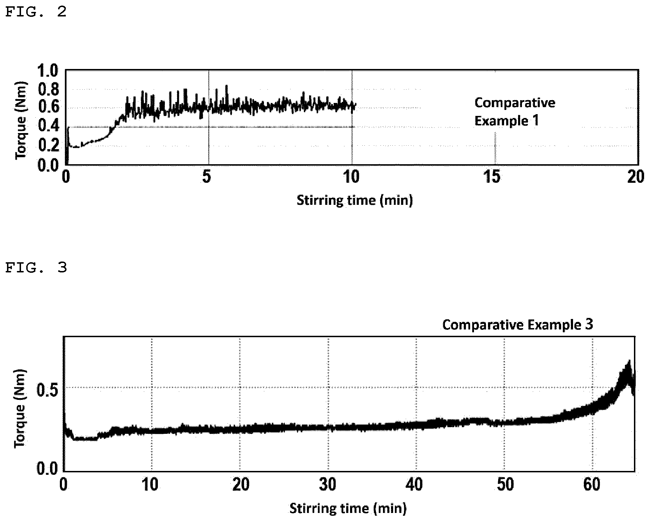

In each of Examples 1 to 5 and Comparative Examples 1 to 6, the encapsulant composition for an optical device manufactured was stirred under conditions of 40°C and 40 rpm, and the soaking completion time of a crosslinking agent was measured and recorded in Table 3 below. Soaking torque values were measured in accordance with stirring time during the soaking, and soaking torque curves were made as in FIGS. 1 to 3.

### (2) Volume resistance

Measurement was conducted by applying a voltage of 1000 V for 600 seconds using an Agilent 4339B High-resistance meter (product of Agilent Technologies K.K.) under temperature conditions of 23 ± 1°C and humidity conditions of 50% ± 3.

### (3) Light transmittance

Light transmittance at 200 nm to 1,000 nm was measured using Shimadzu UV-3600 spectrophotometer to obtain a light transmittance curve, and the values of 280 nm to 380 nm and the values of 380 nm to 1,100 nm were confirmed.
- Measurement mode: transmittance
- Wavelength interval: 1 nm
- Measurement rate: medium

### (4) Measurement of adhesiveness

40% of the area of a glass substrate was covered with an encapsulant film, and the remaining 60% was covered with a polyimide film, and then, a fluorine-based sunlight back sheet was laminated thereon. Lamination was conducted at a temperature of 150°C for 20 minutes so that the encapsulant film was crosslinked and attached to the glass substrate. Cuts were made with a knife in the encapsulant film of the specimen so that the width of a part to be measured was 1 cm.

On a tensile compression tester (LRX Plus Universal Test Machine, manufactured by LLOYD Co.), a sample holder for UTM, and a lad cell of 1 kN were installed. The ends of the encapsulant film attached on the glass substrate and a part on which the encapsulant film was not attached were fixed, respectively, and pulled by 60 mm/min to test the adhesiveness.

### (5) Measurement of degree of crosslinking

A crosslinked sheet was cut into a size of 3 × 3 mm² using scissors. The sides and bottom of a 200 mesh wire netting of 7 × 10 cm² were blocked using a staple. The sheet was injected into the wire netting, and the weight of the sheet injected was measured. The amount of the sheet was controlled to be 0.49 to 0.51 g. After injecting the sheet, the top of the wire netting was blocked using a staple, and the total weight of a sample was measured. To a 2 L cylinder reactor, a solution of 10 g of dibutyl hydroxytoluene (BHT) dissolved in 1,000 g of xylene was poured, and three to four samples were injected thereinto. The reactor was heated, and after 5 hours from a point of initiating boiling, refluxing was terminated. The samples in the reactor were taken out using a metal landing net and washed with xylene. The samples were dried in vacuum at 100°C overnight. The weights of the dried samples were measured, and the degree of crosslinking was calculated. The degree of crosslinking was determined by the average value of three to four samples refluxed in xylene.

Degree of crosslinking (%) = [(weight of sheet before refluxing)/(weight of sheet after refluxing)] × 100

**[Table 2]**

| | Soaking rate | | Volume resistan ce after crosslin king (Ω·cm) | Light transmittanc e (%) | | Adhes ivene ss (N/cm ) | Degre e of cross linki ng (%) |
|---|---|---|---|---|---|---|---|
| | Soaki ng compl etion time (min) | Shorteni ng ratio of completi on time against Comparat ive Example 3 (%) | | After cross linki ng (280-380 nm) | After crossl inking (380-1100 nm) | | |
| Example 1 | 34 | 41 | 1.38×10¹⁷ | 88.6 | 92.3 | 235 | 71.3 |
| Example 2 | 19 | 67 | 4.04×10¹⁷ | 87.7 | 92.2 | 208 | 72.6 |
| Example 3 | 9 | 84 | 5.53×10¹⁷ | 88.0 | 92.2 | 218 | 73.3 |
| Example 4 | 5 | 91 | 7.60×10¹⁷ | 86.9 | 92.2 | 224 | 67.6 |
| Example 5 | 4 | 93 | 1.04×10¹⁸ | 85.1 | 92.2 | 212 | 67.1 |
| Comparative Example 1 | 2 | 97 | 1.70×10¹⁴ | - | - | 160 | 94.3 |
| Comparative Example 2 | 6 | - | 4.63×10¹⁶ | 87.6 | 92.1 | 219 | 43.1 |
| Comparative Example 3 | 58 | 0 | 4.44×10¹⁶ | 87.3 | 92.1 | 204 | 76.9 |
| Comparative Example 4 | 4 | 93 | 5.00×10¹⁶ | - | - | - | 72.3 |
| Comparative Example 5 | 3 | 95 | 5.50×10¹⁶ | 88.1 | 91.9 | 103 | 61.3 |
| Comparative Example 6 | 23 | 60 | 5.78×10¹⁶ | 87.9 | 92.1 | 184 | 68.1 |

Referring to Table 2, it could be confirmed that the encapsulant compositions for an optical device of Examples 1 to 5 showed higher volume resistance after crosslinking when compared to the encapsulant compositions for an optical device of Comparative Examples 1 to 6. Such results were the same for Comparative Example 1 in which commonly used EVA was used instead of an olefin-based copolymer as a resin component, and Comparative Examples 2 to 6, in which ethylene 1-butene copolymer was used like the Examples. Through the results, it could be confirmed that the encapsulant compositions for an optical device showed even higher volume resistance after crosslinking by the tetravinyltin (TVT) used in Examples 1 to 5. In addition, Examples 1 to 5 showed improved soaking rate of a crosslinking agent when compared to Comparative Example 3 in which 0.5 phr of triallyl isocyanurate (TAIC) was used, and it could be confirmed that the soaking rate of a crosslinking agent increased with the increase of the ratio used of the tetravinyltin (TVT). Examples 1 to 3 are examples using tetravinyltin (TVT) and triallyl isocyanurate (TAIC) together, and Examples 4 and 5 are examples using tetravinyltin (TVT) solely. Through the results, it could be confirmed that the exclusive use of tetravinyltin (TVT), or the mixed use of tetravinyltin (TVT) and triallyl isocyanurate (TAIC) is possible, and the mixing ratio could be determined by increasing the amount used of tetravinyltin (TVT) to increase the volume resistance after crosslinking and by increasing the amount used of triallyl isocyanurate (TAIC) to increase the degree of crosslinking. In addition, it could be confirmed that further improved volume resistance value after crosslinking could be obtained by the exclusive use of tetravinyltin (TVT), and the improving effects of the degree of crosslinking to a high level could be obtained by the exclusive use of tetravinyltin.

## Claims

1. An encapsulant composition for an optical device, the encapsulant composition comprising:
(1) an olefin-based copolymer;
(2) a crosslinking agent;
(3) a silane coupling agent; and
(d) a compound represented by the following Formula 1: 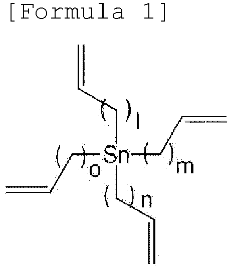 in Formula 1, l, m, n, and o are each independently an integer of 0 to 4.

2. The encapsulant composition for an optical device according to claim 1, wherein the (1) olefin-based copolymer satisfies the following conditions:
(a) a density of 0.85 to 0.90 g/cc, and
(b) a melt index of 0.1 to 100 g/10 min.

3. The encapsulant composition for an optical device according to claim 1, wherein the (1) olefin-based copolymer is an ethylene alpha-olefin copolymer.

4. The encapsulant composition for an optical device according to claim 1, wherein the (1) olefin-based copolymer has a volume resistance of 1.0 × 10¹⁵ Ω·cm or more.

5. The encapsulant composition for an optical device according to claim 1, wherein the crosslinking agent is one or two or more selected from the group consisting of an organic peroxide, a hydroperoxide and an azo compound.

6. The encapsulant composition for an optical device according to claim 1, wherein the crosslinking agent is one or more selected from the group consisting of t-butylcumylperoxide, di-t-butyl peroxide, di-cumyl peroxide, 2,5-dimethyl-2,5-di(t-butylperoxy)hexane, 2,5-dimethyl-2,5-di(t-butylperoxy)-3-hexyne, cumene hydroperoxide, diisopropyl benzene hydroperoxide, 2,5-dimethyl-2,5-di(hydroperoxy)hexane, t-butyl hydroperoxide, bis-3,5,5-trimethylhexanoyl peroxide, octanoyl peroxide, benzoyl peroxide, o-methylbenzoyl peroxide, 2,4-dichlorobenzoyl peroxide, t-butylperoxy isobutyrate, t-butylperoxy acetate, t-butylperoxy-2-ethylhexylcarbonate (TBEC), t-butylperoxy-2-ethylhexanoate, t-butylperoxy pyvalate, t-butylperoxy octoate, t-butylperoxyisopropyl carbonate, t-butylperoxybenzoate, di-t-butylperoxyphthalate, 2,5-dimethyl-2,5-di(benzoylperoxy)hexane, 2,5-dimethyl-2,5-di(benzoylperoxy)-3-hexyne, methyl ethyl ketone peroxide, cyclohexanone peroxide, azobisisobutyronitrile and azobis(2,4-dimethylvaleronitrile).

7. The encapsulant composition for an optical device according to claim 1, wherein the silane coupling agent is one or more selected from the group consisting of N-(β-aminoethyl)-γ-aminopropyltrimethoxysilane, N-(β-aminoethyl)-γ-aminopropylmethyldimethoxysilane, γ-aminopropyltriethoxysilane, γ-glycidoxypropyltrimethoxysilane, γ-methacryloxypropyltrimethoxysilane (MEMO), vinyltrimethoxysilane, vinyltriethoxysilane, 3-methacryloxypropyl methyldimethoxysilane, 3-methacryloxypropyl methyldiethoxysilane, 3-methacryloxypropyl triethoxysilane, and p-styryl trimethoxysilane.

8. The encapsulant composition for an optical device according to claim 1, wherein, in Formula 1, l, m, n, and o are each independently an integer of 0 to 2.

9. The encapsulant composition for an optical device according to claim 1, wherein the compound of Formula 1 is tetravinyltin.

10. The encapsulant composition for an optical device according to claim 1, wherein the encapsulant composition for an optical device comprises:
(1) 80 to 99 parts by weight of the olefin-based copolymer;
(2) 0.1 to 9 parts by weight of the crosslinking agent;
(3) 0.01 to 2 parts by weight of the silane coupling agent; and
(d) 0.1 to 9 parts by weight of the compound of Formula 1.

11. The encapsulant composition for an optical device according to claim 1, wherein the encapsulant composition for an optical device further comprises (5) a crosslinking auxiliary agent in addition to the compound of Formula 1, and
the (5) crosslinking auxiliary agent comprises one or more of an allyl group or a (meth)acryloxy group.

12. The encapsulant composition for an optical device according to claim 11, wherein the (5) crosslinking auxiliary agent comprises one or more selected from the group consisting of triallyl isocyanurate (TAIC), triallyl cyanurate, diallyl phthalate, diallyl fumarate, diallyl maleate, ethylene glycol diacrylate, ethylene glycol dimethacrylate, and trimethylolpropane trimethacrylate.

13. The encapsulant composition for an optical device according to claim 10, wherein a weight ratio of the (4) compound of Formula 1 and the (5) crosslinking auxiliary agent is 20:80 to 80:20.

14. An encapsulant film for an optical device, the encapsulant film comprising an olefin-based copolymer and a compound of the following Formula 1: 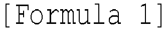 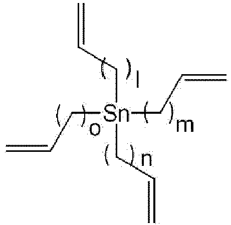 in Formula 1, l, m, n, and o are each independently an integer of 0 to 4.

15. An optical device module, comprising an optical device, and the encapsulant film for an optical device according to claim 14.
